Europäisches Patentamt

European Patent Office

Office européen des brevets

(11) Publication number: **0 455 145 A2**

# EUROPEAN PATENT APPLICATION

(21) Application number: **91106726.2**

(22) Date of filing: **25.04.91**

(51) Int. Cl.⁵: **H04N 5/04, H04N 5/50**

(30) Priority: **30.04.90 US 513445**

(43) Date of publication of application:
**06.11.91 Bulletin 91/45**

(84) Designated Contracting States:
**DE ES GB IT**

(71) Applicant: **THOMSON CONSUMER ELECTRONICS, INC.**
**600 North Sherman Drive**
**Indianapolis Indiana 46201(US)**

(72) Inventor: **Tults, Juri**
**5337 Hawks Point Road**
**Indianapolis, Indiana(US)**

(74) Representative: **Einsel, Robert, Dipl.-Ing.**
**Deutsche Thomson-Brandt GmbH Patent-
und Lizenzabteilung Göttinger Chaussee 76
W-3000 Hannover 91(DE)**

(54) Sync validity detection utilizing a microcomputer.

(57) A tuning system includes a microcomputer-based synchronization signal detector which does not require the use of a hardware timer/counter. The microcomputer (117) samples the output signal of a sync separator (111) coupled to an ordinary input/output port (143) during a number of different evaluation intervals to determine if respective characteristics of a valid sync signal occur. During one evaluation interval, a test is performed to determine if a "high" level is present for a time duration less than a given time duration (e.g., 10μS) corresponding to the maximum duration of horizontal sync pulses. During another evaluation interval, a test is performed to determine if a "low" level is present for a time duration greater than another given time duration (e.g., 40μS) corresponding to the minimum separation between horizontal sync pulses. The sampling intervals and evaluation intervals are established by the time required to execute instruction cycles.

EP 0 455 145 A2

## Field of the Invention

The present invention concerns a method and apparatus, utilizing a microcomputer, for determining when a synchronization component of a video signal is correct.

## Background

Tuning systems which are capable of tuning television signals with non-standard carrier frequencies, as well as with standard (i.e., "broadcast") carrier frequencies, include provisions for changing the frequency of the local oscillator signal in order to search a range of frequencies and provisions for detecting when proper tuning has been achieved. The latter provisions usually include apparatus for examining an automatic fine tuning (AFT) signal representing the frequency relationship between the IF signal and a nominal value, and also apparatus for determining whether or not the demodulated signal produced by the video detector contains picture synchronization ("sync") information. The test for synchronization information is performed as a verification that the RF carrier which has been found during the search is a picture carrier and not a sound carrier because the AFT signal may exhibit conditions corresponding to proper tuning in response to either a picture or a sound carrier. Such a tuning system is described in U.S. patent 4,868,892 issued to J. Tults et al. on September 19, 1989.

A hardware implementation, i.e., one using dedicated logic elements, of a so-called "sync presence" detector for evaluating the output signal of a synchronization (sync) signal separator of the television receiver in order to determine whether valid picture synchronization information is present is disclosed in U.S. patent 4,364,094 issued to J. Tults on December 14, 1982.

In a modern television receiver, most control functions, including tuning, are performed by a microcomputer (μC). It is therefore desirable to use the μC for sync presence detection also.

Most μCs include a hardware counter for performing various timer and/or counter functions. If it is possible to couple the output signal of a sync separator to the timer/counter of the μC through an input port, a simple method for detecting presence of sync information utilizing the μC is to enable the time/counter to count transitions of the output signal of the sync separator during a predetermined time interval. If the count reaches a predetermined number, an indication of a valid sync component is generated.

The technique described above requires a μC with an "on-board" timer/counter which is externally accessible.

Even if a μC includes an externally accessible timer/counter, it is usually desirable to employ the timer/counter to perform other important functions, such as time keeping and decoding of remote control IR commands, which should not be interrupted.

Another problem associated with the use of a hardware counter/timer of a μC is that a seemingly correct result may be obtained under the wrong circumstances, e.g., when the output signal of the sync separator includes randomly spaced noise pulses.

## Summary of the Invention

The present invention, in part, concerns a software controlled "sync presence" detector which does not require a hardware timer counter. Accordingly, if a timer/counter is available in a μC, it may be used for other purposes. In accordance with one aspect of the invention, the output signal of the sync separator is coupled to an ordinary, general purpose input port of the μC and is asynchronously sampled at sampling intervals during a number of evaluation intervals. The sampling intervals and the evaluation intervals are each established by the time required to execute a respective set of instructions, rather than by a hardware timer. During each evaluation interval, it is determined whether or not the output signal of the sync separator has a respective characteristic of a valid sync signal. According to another aspect of the invention, a predetermined number of sequences of positive results during respective evaluation intervals must be produced before an indication of a valid sync signal is provided.

## Brief Description of the Drawing

The invention will be described with reference to the accompanying Drawing in which:
FIGURE 1 shows a block diagram of a television receiver including a tuning system utilizing a microcomputer-based "sync presence detector" constructed and operating in accordance with respective aspects of the present invention; and

FIGURE 2 shows a flow chart of the portion of the control program of the microcomputer of the tuning system shown in FIGURE 1 which is concerned with "sync presence" detection.

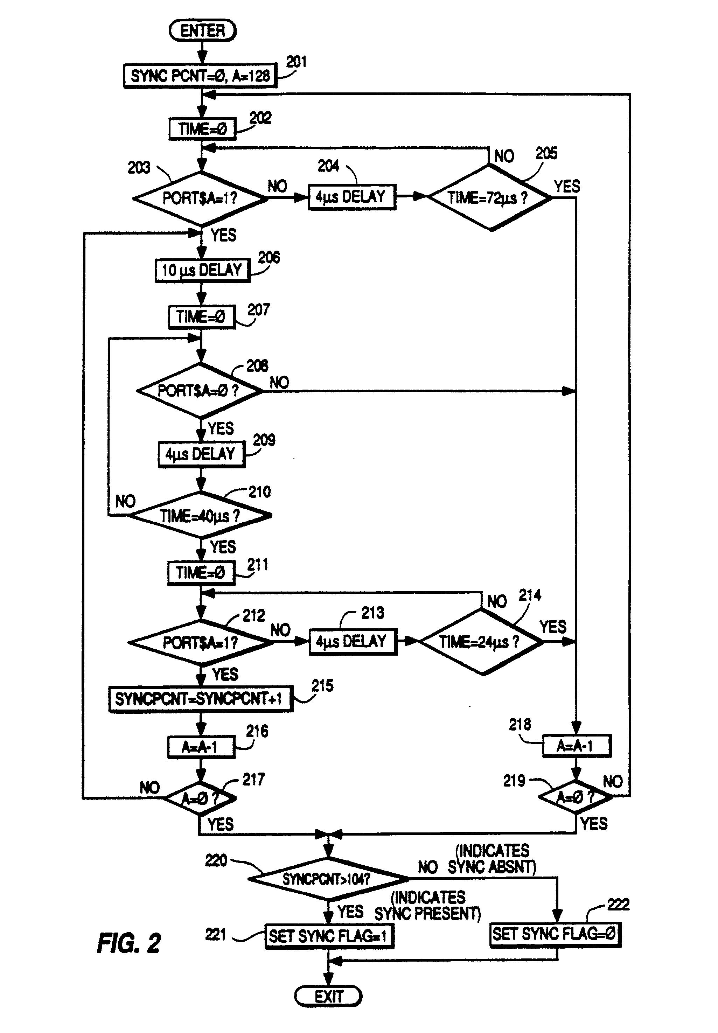

The accompanying Addendum contains a program listing corresponding to the flow chart shown in FIGURE 2.

## Detailed Description of the Embodiment

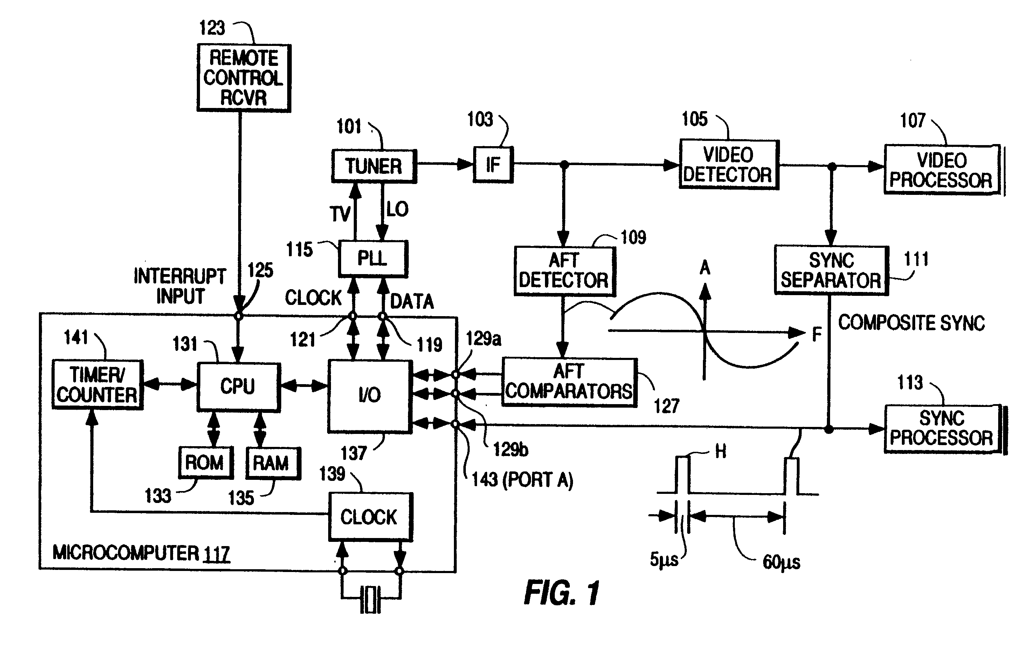

The television receiver shown in Figure 1, includes a tuner 101, an IF section 103, a video detector 105, a video processing section 107, an AFT detector 109, a sync separator 111 and a sync processing section 113 arranged in conventional fashion. When a channel is properly tuned sync separator 111 produces a composite sync signal containing both horizontal and vertical sync pulses.

Tuner 101 includes a local oscillator (not shown) which is part of and controlled by a phase locked loop (PLL) 115. Phase locked loop 115 generates a tuning voltage (TV) in response to an error signal produced by comparing the frequency (and phase) of a signal derived by dividing the frequency of the local oscillator (LO) signal by a controllable division factor N to a reference frequency signal. Division factor N is controlled by a microcomputer ($\mu$C) 117, which also controls various other functions of the television receiver. In the illustrative embodiment, data for controlling division factor N is coupled to PLL 115 from an input/output port (terminal) 119 of $\mu$C 117 in serial fashion. A clock signal, used to decode the serial data, is coupled to PLL 115 from an input/output port 121 of $\mu$C 117.

A user may control various functions of the television receiver, including channel selection, by using a remote control system. Only remote control receiver 123 of the remote control system is shown in Figure 1. Remote control receiver 123 is coupled to a so-called "interrupt" input terminal 125 of $\mu$C 117.

Microcomputer 117 controls division factor N of PLL 115 in accordance with a channel selection made by a user. In order to tune RF television signals with non-standard frequency carriers, as well as with standard frequency carriers, $\mu$C 117 also controls division factor N in accordance with the condition of the automatic fine tuning (AFT) signal generated by AFT detector 109 and the condition of the output signal of sync separator 111.

Specifically, in order to locate and tune RF signals with non-standard frequency carriers, $\mu$C 117 controls division factor N so that the local oscillator frequency is changed in relatively small steps in a search range surrounding the nominal local oscillator frequency for a selected channel. As is shown in Figure 1, the AFT signal has a generally S-shaped amplitude versus frequency characteristic, having positive and negative amplitude regions or "humps" on opposite sides of a nominal frequency value. Threshold comparators within a AFT comparator section 127 determine when the amplitude of the AFT signal is within respective ones of the two amplitude regions. The output signals of the threshold comparators of AFT comparator section 127 are coupled to input/output ports 129a and 129b of $\mu$C 117. The presence of a carrier is indicated when the amplitude of the AFT signal is in the positive amplitude region for one step and then the negative amplitude region for the next step (assuming that the local oscillator frequency is being increased).

Unfortunately, AFT detector 109 may respond in the same way to both picture and sound carriers and tuning errors may occur if sole reliance is placed on the AFT signal. Therefore, the output signal of sync separator 111 is examined to determine whether or not it contains a valid horizontal sync component. A valid sync signal indicates that a picture carrier rather than a sound carrier has been located.

The tuning system described so far is similar to that disclosed in U.S. patent 4,868,892 issued to J. Tults referred to above. However, the present tuning system differs from the tuning system disclosed in the patent in that the output of sync separator 111 is directly evaluated by $\mu$C 117 using a software controlled algorithm rather than by dedicated logic.

Before describing the software algorithm with reference to the flow chart shown in Figure 2, the basic components of $\mu$C 117 will be briefly described so as to better understand the algorithm and certain of its advantages.

Microcomputer 117 includes a central processing unit (CPU) 131 which communicates with a read only memory (ROM) 133 and a random access memory (RAM) 135. Central processing unit 131 processes data stored in RAM 135 in accordance with a set of instructions (i.e., a "program") stored in ROM 133. Data is coupled between CPU 131 and various input/output ports (terminals) through an input/output (I/O) unit 137. A crystal control clock generator 139 provides various clocking and timing signals for various portions of $\mu$C 117.

As earlier noted, $\mu$C 117 has an "interrupt" input terminal 125. When an interrupt signal, e.g., a positive-going pulse, is received at interrupt input terminal 125, CPU 131 immediately interrupts the execution of the main control program and initiates the operation of an "interrupt" program. This operation will be described later by way of example with reference to the decoding of remote control signals coupled to "interrupt" input 125 from remote control receiver 123.

Microcomputer 117 also includes a so-called hardware "timer/counter" 141 coupled to CPU 131. In the exemplary embodiment, timer/counter 141 continuously receives and counts clock pulses of a clock signal generated by clock generator 139. Timer/counter 141 is useful for various timer/counter functions.

By way of example, timer/counter 141 may be used to measure the duration of a portion of a pulse signal by loading an initial count value in to it at the occurrence of a first transition of the pulse signal, determining a final count value at the occurrence of a second transition of the pulse signal and subtracting the two count values. In the present embodiment, the time durations between the pulses of the remote control signal are measured using timer/counter 141 and interrupt input 125 in order to decode the remote control signal. Specifically, when a first remote control pulse is received at "interrupt" input 125, the interrupt program is initiated and causes an initial value to be loaded into timer/counter 141. When a second remote control pulse is received, a final count value reached by timer/counter 141 is determined by CPU 131. The two count values are subtracted from initial value to determine the time duration between the remote control pulses. By way of example, a long duration may correspond to a logic "1" and a short duration may correspond to a logic "0".

In the present embodiment, timer/counter 141 is also used to keep the present time. Each time a maximum count of timer/counter 141 is reached, a count representing the present time stored in the register of RAM 135 is increased.

Timer/counter 141 may also be used to evaluate the output signal of sync separator 111, e.g., by measuring the time interval between positive- or negative-going transitions as previously described. However, in the present embodiment, time/counter 141 and interrupt input 125 is already being used to decode remote control signals. In addition, the use of timer/counter 141 to evaluate the output signal of sync separator 111 is restricted to a relatively simple time duration measurement which is subject to errors.

In the preferred embodiment of the invention, the output of sync separator 111 is evaluated using a software algorithm, rather than hardware timer/counter 141. In addition to leaving the timer/counter free for other functions, the algorithm allows the output signal of sync separator 111 to be coupled to an ordinary general purpose input/output port (terminal) 143 of $\mu$C 117. In the flow chart shown in Figure 2, input/output port 143 is referred to as port A.

A detailed flow chart of the portion of the control program of microcomputer 117 concerned with the determination of whether or not valid sync information present is shown in Figure 2. The corresponding program "listing" and the identification of certain performance characteristics is contained in the accompanying Addendum. The code indicated in the listing is that of a so-called "TELEKAT" television control IC, including a 6805 based microcomputer, available from Motorola Semiconductor Products, Inc. The "TELEKAT" IC also includes a tuner control phase locked loop as well as digital to analog converters for various television control functions, such as brightness, contrast, saturation, color and volume. It also includes a character generator for producing character signals suitable for an "on-screen" display of information such as the channel numbers of presently tuned channels.

Basically, as indicated above, the sync presence algorithm determines whether or not a predetermined number of horizontal sync pulses of approximately the correct time duration (about 5$\mu$S) and approximately correct period (about 64$\mu$S) occur for a given number of test cycles. During each test interval, the software program of $\mu$C 117 "looks" for a positive sync pulse at port A at intervals of 4$\mu$S (microseconds). Sampling at this rate is desirable because normal horizontal sync pulses may have a minimum duration of 4$\mu$S. After detection of a sync pulse, the program continues sampling the input to make sure that the next pulse occurs approximately 60$\mu$S later, as expected.

Several variables stored in RAM 135 of $\mu$C 117 are used in the sync presence detection algorithm indicated in Figure 2:

"A" is a count of how many test cycles for a valid horizontal sync pulse have occurred. 128 test cycles are executed. The number 128 was chosen because it corresponds to approximately one-half of a television field and is long enough to allow for errors due to the double frequency pulses which occur during the vertical blanking interval.

"SYNCPCNT" is a count of how many times a valid horizontal sync pulse has been found to exist. A SYNCPCNT count greater than 104 indicates the presence of correct sync information. The number 104 is chosen since it allows for some incorrect results out of the 128 test cycles. Certain expected incorrect results are due to the double frequency narrow equalizing pulses and wide vertical sync pulses contained within the vertical blanking interval.

The sampling intervals, evaluation intervals and delays utilized in the sync detection program are established by the time required to execute instructions (such as DECX indicated in the listing), rather than by the use of timer/counter 141. More specifically, referring to the listing, the small loops shown in the flow chart are identical in terms of execution time. The BRSET instruction examines the logic level of the output signal of sync separator 111 and is executed in 2.5µS. A DECX and BNE instruction are used alternately between the BRSET instructions and are both executed in 1.5µS. As a result, the execution time of one loop is 8µS and the output signal of sync separator 111 is examined twice at 4µS intervals in each loop. The instruction DECX causes the contents of a register (X) in RAM 135 to be decreased by 1. The instruction BNE checks whether or not the contents of the X register has reached 0 to determine whether or not an alloted time interval has elapsed. However, for the sake of indicating functional operations in a relatively simple manner, variables such as TIME and DELAY are represented in the flow chart as if they were established by a conventional timer/counter.

In the flow chart, the instruction "PORT$A" causes the output signal of sync separator 111 coupled to port A to be sampled. Port A and the instruction PORT$A should not be confused with variable "A".

In the following description of the sync detection algorithm, reference numbers of blocks of the flow chart shown in Figure 2 are indicated, where appropriate.

The sync detection algorithm is initiated ("entered") after the presence of a carrier has been detected by examining the AFT signal during the search operation previously described.

After the sync presence portion of the program is entered, SYNCPCNT is set to a count of 0 and A is set to a count of 128 (201). Thereafter, TIME is set to 0 (202) and port A is sampled every 4µS until the output signal of sync separator 111 is "high" (a logic "1"), or until a period of 72µS has elapsed (203, 204, 205). The time interval of 72µS provides a default or "escape" condition to prevent "lockup" in case a valid sync signal is not present at port A. If a logic "1" has appeared at port A, port A is again sampled after a delay of 10µS to determine if a logic "0" is present (206, 208). Steps 203, 204, 205, 206 and 208 are used to determine if a "high" pulse no longer in duration than 10µS is developed at the output of sync separator 111. A positive (YES) result at step 208 indicates the possible presence of a horizontal sync pulse.

If the result was positive (YES) at step 208, port A continues to be sampled every 4µS until a period of 40µS has elapsed, or until a logic "1" appears at the output of sync separator 111 (208, 209, 210). The timer is initialized for this evaluation at step 207. Steps 208, 209 and 210 are used to determine if the output signal of sync separator 111 is "low" for a period somewhat shorter than the time interval between horizontal sync pulses.

If a 40µS "low" period has been found to exist (208,209,210), port A is again sampled at 4µS intervals until a "high" is detected, or until 24µS have elapsed (211, 212, 213, 214). Steps 211, 212 ,213, and 214 are used to determine if another horizontal sync pulse occurs after the 40µS "low" period. The 24µS time interval provides a default condition.

If two successive "high" periods, corresponding to horizontal sync pulses, separated by at least a 40µS low period, have occurred (YES at 212), the SYNCPCNT count is increased by 1 (215) and the A count is decreased by 1 (216). At this point, if A has not reached 0 (NO at 217), the program returns to step 206 to examine the next interval between pulses.

If any condition indicating an improper sync component is detected during an evaluation cycle (202-214), A is also decreased by 1 (218) but SYNCPCNT is not increased by 1. A failure is indicated when either: (1) no "high" has appeared in 72µS (203, 204, 205); (2) a "high" was longer than 10µS (206, 208) (3) a 40µS "low" has not appeared (208, 209, 210); or (4) a second "high" has not appeared within 24µS (212, 213, 214). At this point, if A has not reached 0 (NO at 219), another evaluation cycle is initiated (202) to look for a horizontal sync pulse.

If A reaches a count of 0 at either step 217 or 219, indicating that 128 complete evaluations have been performed, SYNCPCNT is evaluated (220). If SYNCPCNT is greater than 104, a flag register indicating the presence of a valid sync component is set to a logic "1" (221). Thereafter, the sync presence algorithm is "exited" and the tuning algorithm continues by changing the local oscillator frequency in very small steps until the AFT signal is between its two humps in order to "fine tune" the local oscillator. Alternatively, if SYNCPCNT is not greater than 104, the flag register is set to a logic "0" to indicate that a valid sync component is not present (222). Thereafter, the tuning algorithm continues the search for a picture carrier.

It will be appreciated by those skilled in the art that while the term "microcomputer" has been used in describing the embodiment of the invention, the term "microprocessor", at least in connection with the present invention is synonymous, with microcomputer.

The total time of execution of the sync detection portion of the program is about 8ms (milliseconds). A reasonable number of program interruptions for such functions as checking for user generated commands and controlling various television functions does not significantly affect the performance of the sync detection program. Every interrupt may simply reduce the number of detected sync pulses by a very small number. This can be easily accounted for by reducing the threshold value of the expected sync pulse count (SYNPCNT).

The present invention has been described by way of example in terms of the sync component conforming to the NTSC television signal standard utilized in the United States. However, it will be appreciated by those skilled in the art, that with the teaching provided by the exemplary embodiment, the invention may be applied to sync components conforming to other television signal standards, such as PAL and SECAM.

While the present sync presence detector described with reference to a tuning system in which the presence of sync is used to confirm that a picture carrier rather than a sound carrier has been tuned after an AFT signal initially indicates the presence of a carrier, it will be appreciated that the sync presence detector may be utilized without an AFT detector, e.g., to indicate the presence of television signals. These and other modifications are intended to be within the scope of the present invention defined by the following claims.

ADDENDUM

```
    ;TEST PROGRAM FOR SYNC DETECTOR
    ;
    ;THIS PROGRAM MAXIMIZES THE SAMPLING OF SYNC SIGNAL
    THROUGHOUT THE 64us
    ;PERIOD OF A COMPLETE CYCLE. THE SAMPLING INTERVAL IS 4.0us,
    BASED ON
    ;A MACHINE CYCLE OF .5us FOR THE 6805 CORE OF THE TELEKAT IC.
    ;
    ;PERFORMANCE CHARACTERISTICS FOR "VALID SAMPLE COUNT")64 :
    ;     RF CARRIER LEVEL   -95dB (12uv)
    ;     SYNC PULSE WIDTH 2.7us MIN., 12 us MAX.
    ;     SYNC PULSE FREQUENCY 13.9KHz MIN., 19.8KHz MAX.
    ;
    ;------------------------MAIN   PROGRAM------------------------
     201B 3F 72      START   CLR     SYNCPCNT ;CLEAR VALID SAMPLE
                                              COUNTER
     201D A6 80              LDA     #128     ;INITIALIZE ACC. AS LOOP
                                              COUNTER TO 129
     201F AE 09      FINDHI  LDX     #9
     2021 02 00 08   FINDHIR BRSET   1,PORT$A, ;LOOK FOR HIGH SIGNAL
                                     SIGHIGH   LEVEL AT 4us
     2024 5A                 DECX             ;INTERVALS UP TO 18
                                              TIMES
     2025 02 00 04           BRSET   1,PORT$A,
                                     SIGHIGH
     2028 26 F7              BNE     FINDHIR
     202A 20 1B              BRA     ENDLOOP
     202C AE 02      SIGHIGH LDX     #2
     202E 5A         DONTCR  DECX             ;UPON DETECTION OF HIGH
                                              SIGNAL LEVEL WAIT
     202F 26 FD              BNE     DONTCR   ;ABOUT 10us TO ALLOW FOR
                                              NEG. TRANSITION
     2031 AE 05      GAP     LDX     #5
     2033 02 00 11   GAPR    BRSET   1,PORT$A, ;REQUIRE GAP BETWEEN
                                     ENDLOOP   PULSES TO BE AT LEAST
     2036 5A                 DECX             ;ABOUT 40us WIDE  WHILE
                                              SAMPLING
     2037 02 00 0D           BRSET   1,PORT$A, ; THE SIGNAL AT 4us
                                     ENDLOOP   INTERVALS
     203A 26 F7              BNE     GAPR
     203C AE 03              LDX     #3
     203E 02 00 08   GAPEXT  BRSET   1,PORT$A, ;LOOK FOR NEXT POS.
                                     VALIDS    TRANSITION WITHIN THE
     2041 5A                 DECX             ; NEXT 24us BY SAMPLING
                                              AT 4us INTERVALS
     2042 02 00 07           BRSET   1,PORT$A,
                                     VALIDS
     2045 26 F7              BNE     GAPEXT
     2047 4A         ENDLOOP DECA             ;IF NOT FOUND, DECREMENT
                                              LOOP COUNTER AND
     2048 26 D5              BNE     FINDHI   ;RESTART LOOKING FOR
                                              HIGH SIGNAL LEVEL
     204A 20 05              BRA     FINISH
     204C 3C 72      VALIDS  INC     SYNCPCNT ;IF SUCCESSFUL, INCR.
                                              VALID SAMPLE COUNTER,
     204E 4A                 DECA             ;DECREMENT LOOP COUNTER
                                              AND START
     204F 26 E0              BNE     GAP      ;MEASURING GAP BETWEEN
                                              PULSES
                     ;---UPDATE MINIMUM AND MAXIMUM COUNT MEMORIES-----
     2051 B6 72      FINISH  LDA     SYNCPCNT
     2053 B0 71              SUB     MINCNT   ;CHECK WHETHER MIN.
                                              VALID SAMPLE COUNT
                             RTS              ;EXIT SUBROUTINE WITH
                                              RESULT IN ACC.
```

## Claims

1. Apparatus for evaluating a synchronization component of a television signal, comprising:
a microcomputer (117) including a central processing unit (131); a plurality of ports; and means for coupling said ports to said processing unit (137);

memory means (133;135) coupled to said central processing unit (131) of said microcomputer (117) for storing a program of instructions for controlling said microcomputer;

means (111) receiving said television signal at an input for developing said synchronization component (composite sync) at an output; said output being coupled to one (143) of said ports of said microcomputer (117); characterized in that

said control program includes a portion causing said microcomputer (117) to sample an output signal produced at said output during a plurality of evaluation intervals in which sampled characteristics of said output signal are evaluated by said microcomputer to determine if said sampled characteristics correspond to respective characteristics of a correct synchronization component.

2. The apparatus recited in Claim 1, further characterized in that

sampling intervals and said evaluation intervals are established by the time required to execute respective instructions.

3. The apparatus recited in Claim 2, further characterized in that

said output signal is sampled during one of said evaluation intervals to determine if said output signal has a first level for a time duration no greater than a given time duration related to the maximum time duration of horizontal synchronization pulses;

said output signal is sampled during another one of said evaluation intervals to determine if said output signal has a second level, different from said first level, for a time duration greater than another given time duration related to the minimum time duration between horizontal synchronization pulses.

4. The apparatus recited in Claim 3, further characterized in that

said evaluation intervals are repeated in a given sequence for a predetermined number of cycles;

a count variable is increased if a positive determination in each evaluation interval of a cycle is made; and

an indication that said output signal corresponds to said synchronization component is generated if said count variable is greater than a predetermined number after said predetermined number of cycles has occurred.

5. The apparatus recied in Claim 1, further characterized in that

said ports of said microcomputers are general purpose ports.

**FIG. 1**

**FIG. 2**

ENTER

SYNC PCNT=0, A=128 — 201

TIME=0 — 202

203 — PORT$A=1?
NO → 4µs DELAY — 204 → TIME=72µs ? — 205
NO
YES

YES

10 µs DELAY — 206

TIME=0 — 207

208 — PORT$A=0 ? — NO

YES

4µs DELAY — 209

NO — TIME=40µs ? — 210

YES

TIME=0 — 211

212 — PORT$A=1?
NO → 4µs DELAY — 213 → TIME=24µs ? — 214
NO
YES
YES

SYNCPCNT=SYNCPCNT+1 — 215

A=A-1 — 216

218 — A=A-1

217 — A=0 ?
NO
YES

219 — A=0 ?
NO
YES

220 — SYNCPCNT>104?
NO (INDICATES SYNC ABSNT)
YES (INDICATES SYNC PRESENT)

221 — SET SYNC FLAG=1

SET SYNC FLAG=0 — 222

EXIT